(19) Europäisches Patentamt / European Patent Office / Office européen des brevets

(11) **EP 2 136 401 A1**

(12) **DEMANDE DE BREVET EUROPEEN**

(43) Date de publication:
**23.12.2009 Bulletin 2009/52**

(51) Int Cl.:
*H01L 23/52* (2006.01)  *H01L 21/50* (2006.01)
*H01L 25/00* (2006.01)  *H01L 25/065* (2006.01)
*H01L 23/522* (2006.01)  *H01L 21/98* (2006.01)

(21) Numéro de dépôt: **09172209.0**

(22) Date de dépôt: **12.12.2000**

(84) Etats contractants désignés:
**DE GB IT**

(30) Priorité:  **15.12.1999  FR 9915838**

(62) Numéro(s) de document de la (des) demande(s) initiale(s) en application de l'article 76 CBE:
**00993460.5 / 1 238 431**

(71) Demandeur: **3D Plus**
**78532 Buc Cedex (FR)**

(72) Inventeur: **Val, Christian**
**78470 St Remy Les Chevreuse (FR)**

(74) Mandataire: **Henriot, Marie-Pierre et al**
**Marks & Clerk France**
**Conseils en Propriété Industrielle**
**Immeuble " Visium "**
**22, avenue Aristide Briand**
**94117 Arcueil Cedex (FR)**

Remarques:
Cette demande a été déposée le 05-10-2009 comme demande divisionnaire de la demande mentionnée sous le code INID 62.

(54) **Procédé et dispositif d'interconnexion en trois dimensions de composants électroniques**

(57)    L'invention concerne un procédé et un dispositif d'interconnexion en trois dimensions de composants électroniques.

Pour diminuer les capacités parasites entre connexions et blindage (304) du dispositif, on découpe, dans le bloc (3') de circuits empilés dont les conducteurs (21) sont en retrait de la face correspondante (302) du bloc, des rainures (40, 41) métallisées (42), ces rainures venant entamer les conducteurs de connexion (21). L'ensemble est ensuite enrobé de résine (303) et blindé par une métallisation (304).

L'invention s'applique notamment à la réalisation de systèmes électroniques en trois dimensions à encombrement réduit.

FIG.6

## Description

L'invention se rapporte à un procédé d'interconnexion en trois dimensions de boîtiers ou circuits contenant au moins un composant électronique.

La réalisation des systèmes électroniques actuels doit tenir compte d'exigences de plus en plus grandes en termes de compacité, du fait du nombre de plus en plus élevé de circuits mis en oeuvre, et de rapidité de fonctionnement. Dans un but de compacité, il a déjà été proposé de réaliser des empilements de puces de circuits intégrés, comme décrit dans le brevet français FR 2 670 323, ou de boîtiers encapsulant des pastilles semiconductrices, comme décrit dans le brevet français FR 2 688 630, l'interconnexion des puces ou boîtiers s'effectuant en trois dimensions en utilisant les faces de l'empilement comme surfaces d'interconnexion.

Cependant, comme ces blocs de boîtiers ou circuits empilés sont ensuite généralement enrobés d'un matériau électriquement isolant puis blindés par dépôt d'une couche de métallisation, il existe des capacités parasites non négligeables entre les connexions tracées sur les surfaces de l'empilement et le blindage. Ceci constitue un inconvénient important, notamment dans la recherche de la rapidité de fonctionnement des composants.

La présente invention a pour objet de remédier à cet inconvénient en interconnectant les conducteurs des boîtiers ou circuits non plus par des connexions tracées sur les surfaces du bloc mais par des connexions empruntant des rainures perpendiculaires à la face du bloc.

Selon l'invention, il est donc prévu un procédé d'interconnexion en trois dimensions de boîtiers ou circuits contenant au moins un composant électronique et munis de conducteurs de connexion, dans lequel lesdits boîtiers ou circuits sont empilés et solidarisés par enrobage à l'aide d'un matériau électriquement isolant pour former un bloc, ledit procédé étant **caractérisé en ce qu**'il comporte les étapes suivantes :

    a) découpe du bloc en laissant les extrémités des conducteurs en retrait par rapport aux faces correspondantes du bloc ;
    b) découpe dans lesdites faces et perpendiculairement à celles-ci de rainures venant entamer respectivement l'extrémité desdits conducteurs ;
    c) métallisation du bloc et de ses rainures ;
    d) polissage desdites faces du bloc pour éliminer la métallisation de ces faces ;
    e) enrobage de l'ensemble du bloc par un matériau électriquement isolant.

L'invention prévoit également un dispositif électronique à interconnexion en trois dimensions comportant des boîtiers ou circuits contenant au moins un composant électronique et munis de conducteurs de connexion, dans lequel lesdits boîtiers ou circuits sont empilés et enrobés par un matériau électriquement isolant pour former un bloc, **caractérisé en ce que** les extrémités desdits conducteurs sont en retrait par rapport aux faces correspondantes du bloc, en ce que lesdites faces comportent des rainures entamant les extrémités respectives desdits conducteurs et dont les faces portent une métallisation et en ce que ledit bloc comporte un matériau électriquement isolant enrobant l'ensemble du bloc et des rainures.

Grâce à ces dispositions, seules les sections des métallisations des rainures affleurent à la surface du bloc vis-à-vis de la métallisation de blindage, d'où une diminution considérable des capacités parasites. En outre, le fait que l'ensemble des surfaces latérales internes des rainures soient métallisées et participent à la conduction accroît notablement la section des connexions et donc les possibilités d'acheminement de courants importants sans pour autant augmenter l'écartement des connexions.

Un autre aspect de l'invention consiste à profiter des rainures ainsi obtenues pour réaliser des barres omnibus d'alimentation ("Bus bar" dans la littérature anglo-saxonne) à condensateur réparti en formant, par découpe du fond d'une rainure, deux électrodes se faisant face pour le réseau Masse-Alimentation.

Selon cet autre aspect de l'invention, il est donc prévu un procédé du type ci-dessus, **caractérisé en ce que**, lors de l'étape b), au moins l'une prédéterminée desdites rainures vient entamer l'extrémité de deux conducteurs adjacents d'alimentation desdits boîtiers ou circuits et en ce que ledit procédé comprend en outre, entre les étapes c) et e), l'insertion d'une étape de :

    g) découpe, dans le fond desdites rainures prédéterminées et sur toute leur longueur, de secondes rainures.

L'invention prévoit également un dispositif du type ci-dessus,
**caractérisé en ce que** des rainures prédéterminées entament les extrémités de deux conducteurs adjacents et en ce que la métallisation du fond desdites rainures prédéterminées est interrompue sur toute la longueur desdites rainures.

On peut ainsi obtenir des modules avec barre omnibus intégrée ou reportée d'encombrement réduit et à faible coût.

L'invention sera mieux comprise et d'autres caractéristiques et avantages apparaîtront à l'aide de la description ci-après et des dessins joints où :

-   les figures 1 à 3 représentent un dispositif à interconnexion en trois dimensions de type connu ;
-   la figure 4 montre l'organigramme d'un mode de réalisation du procédé selon l'invention ;
-   la figure 5 représente une étape de fabrication du dispositif selon l'invention ;
-   la figure 6 est une vue partielle d'un mode de réalisation du dispositif selon l'invention ;

- les figures 7A et 7B montrent un détail de variantes du dispositif selon l'invention ;
- la figure 9 illustre une étape de la fabrication d'un dispositif selon le procédé de la figure 8 ;
- la figure 10 est une vue partielle du dispositif selon l'invention obtenu selon cette variante de procédé.
- la figure 11 représente le dispositif selon l'invention obtenu selon cette variante de procédé dans une autre application ; et
- la figure 12 est une vue d'une variante du dispositif de la figure 10.

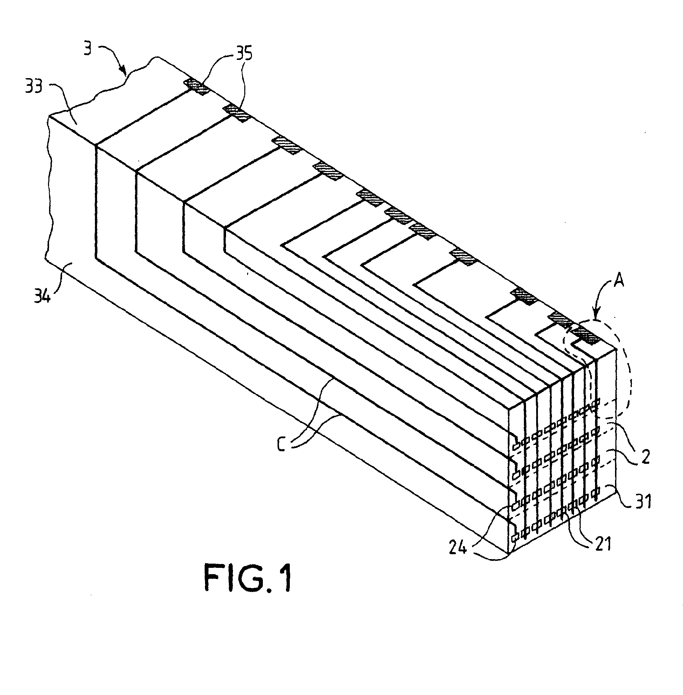

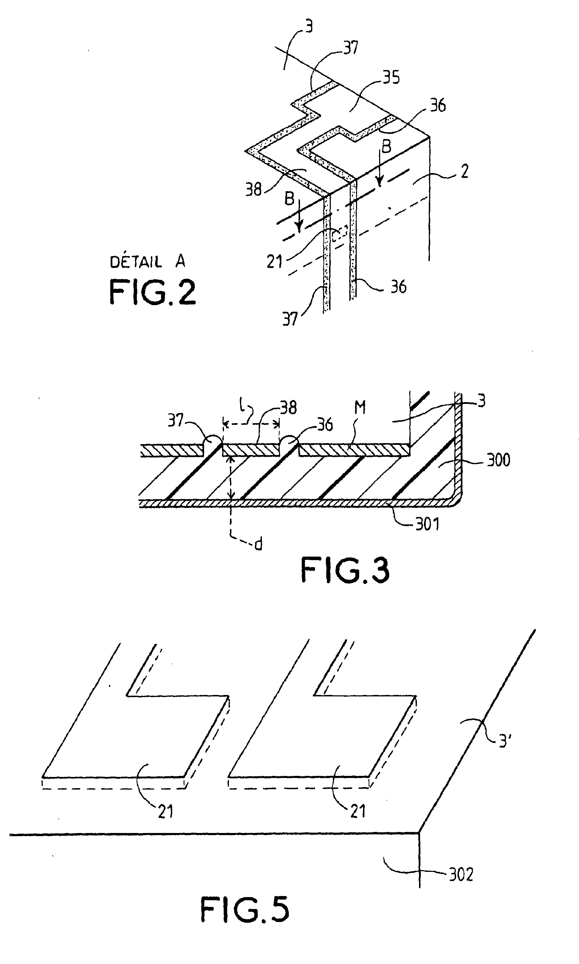

La figure 1 représente une vue partielle d'un dispositif à interconnexions en trois dimensions connu selon le brevet FR 2 688 630, la figure 2 un détail A de la figure 1 et la figure 3 une coupe selon B-B de la figure 2.

Ce dispositif connu est formé par empilement de boîtiers ou circuits 2 munis de conducteurs de connexion 21 et solidarisation par enrobage à l'aide d'un matériau électriquement isolant de manière à former un bloc 3. Ce matériau est choisi de préférence pour qu'il soit thermomécaniquement adapté au matériau formant le boîtier ou le circuit de façon à faciliter la dissipation thermique et à éviter les contraintes ou ruptures éventuelles dues à des différences trop grandes dans les valeurs des coefficients de dilatation des matériaux. On peut utiliser par exemple une résine polymérisable telle qu'une résine époxy.

Le bloc est découpé et poli pour former des faces 31, 33, 34, de manière telle que les conducteurs de connexion des boîtiers affleurent les faces correspondantes du bloc (face 31 sur la figure 1). Une métallisation est ensuite réalisée sur l'ensemble des faces du bloc puis les connexions C sont découpées par exemple par gravure laser.

Sur la figure 2 est montré le détail A de la figure 1. On y voit une connexion 38 entre les conducteurs adéquats 21 des différents boîtiers, cette connexion aboutissant à un plot 35 pour la liaison électrique à des circuits extérieurs.

La connexion 38 et le plot 35 sont obtenus par gravure 36, 37, par exemple par laser, détruisant localement la couche de métallisation conductrice M.

La coupe selon B-B de la figure 3 illustre le dispositif terminé.

Le bloc 3 avec la métallisation M, les gravures 36 et 37 et la connexion 38 de largeur $\ell$ est enrobé dans un matériau électriquement isolant 300 sur une épaisseur $\underline{d}$ et une métallisation de blindage 301 est déposée sur l'ensemble.

On peut constater que, du fait que l'épaisseur $\underline{d}$ est faible, une capacité parasite non négligeable apparaît entre la connexion 38 et la métallisation 301. Cette capacité est de la forme :

$$C = \varepsilon_v\, \varepsilon_0\, \frac{A}{d}$$

où A est l'aire des surfaces en regard, $\varepsilon_0 = 8{,}86.10^{-12}$ F/m et $\varepsilon_v$ est la permittivité du matériau 300 enrobant le bloc (par exemple de l'ordre de 4).

Par exemple, si l'on suppose une largeur $\ell$ de connexion égale à 350 $\mu$m et une épaisseur $\underline{d}$ égale à 100 $\mu$m, pour une longueur de connexion unité, 1 mm, on obtient :

$$C = 12{,}4.10^{-14}\ F$$

soit environ 0,125 pF par mm.

Pour une longueur de connexion 38 de 10 mm, on obtient déjà une capacité parasite de 1,25 pF, ce qui peut constituer un inconvénient important pour des circuits fonctionnant de plus en plus rapidement avec des tensions d'alimentation réduites.

La solution selon l'invention consiste à réduire dans de larges proportions les surfaces en regard des connexions et du blindage, ce qui réduit notablement les capacités parasites.

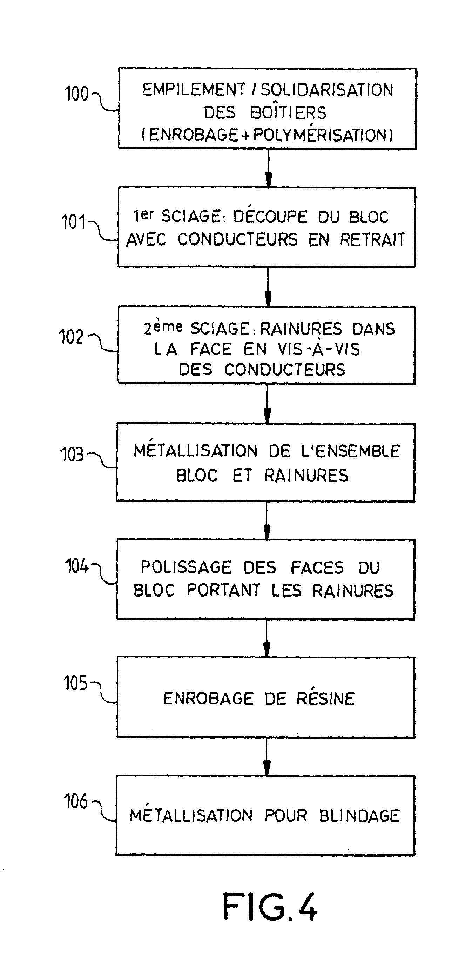

La figure 4 illustre donc un mode de réalisation du procédé selon l'invention.

La première étape du procédé, 100, ne change pas par rapport à l'art antérieur. On empile les boîtiers ou circuits et on les solidarise par enrobage de l'ensemble par un matériau électriquement isolant, tel qu'une résine qu'on polymérise.

L'étape suivante 101 consiste à découper l'empilement solidarisé de sorte que les conducteurs de connexion 21 des boîtiers ou circuits soient en retrait par rapport à la face correspondante du bloc. Ceci est représenté sur la figure 5. On y voit le bloc 3' obtenu après l'étape 101 avec les extrémités des conducteurs 21 du boîtier supérieur. Le plan de découpe, par exemple par sciage, est matérialisé par la face 302 du bloc 3'.

Le retrait des conducteurs 21 par rapport à la face 302 peut être de quelques micromètres à quelques centaines de micromètres.

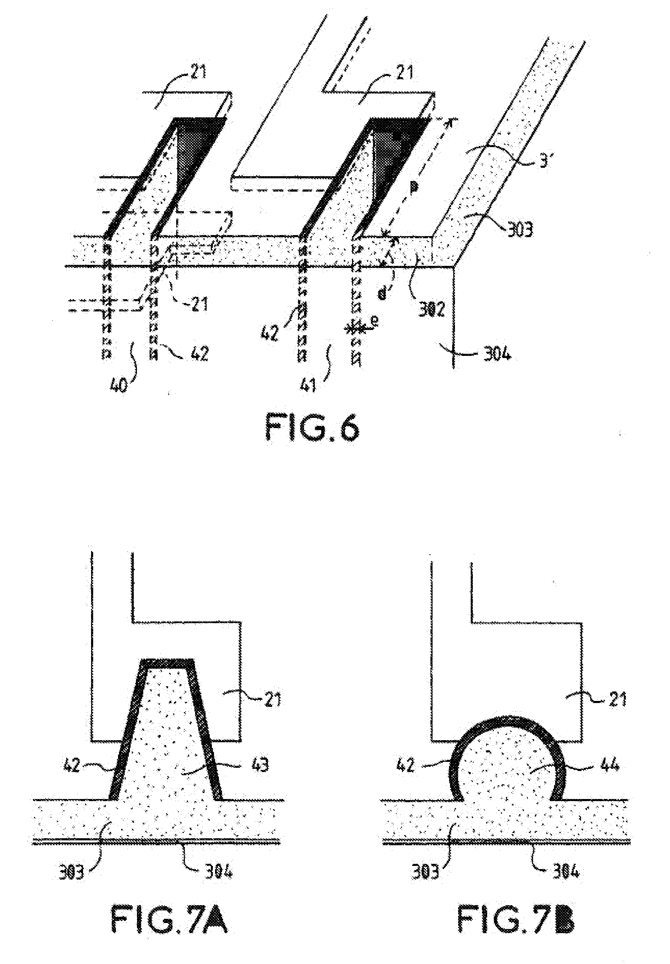

L'étape suivante 102 consiste à réaliser des rainures perpendiculaires à la face 302 et au plan des boîtiers sur une profondeur suffisante pour entamer l'extrémité des conducteurs 21 en retrait. L'extrémité de ces conducteurs est plus large que les rainures au niveau de la jonction entre la rainure et le conducteur. L'entame peut ainsi être incluse selon sa largeur dans l'extrémité du conducteur (21) comme montré figures 7A et 7B.

On obtient ainsi une section qui pourra être métallisée.

L'étape suivante 103 consiste à déposer une (ou plusieurs) couche(s) conductrice(s), métallique(s) par exemple, sur l'ensemble des faces du bloc 3' et des rainures précédemment réalisées.

L'étape suivante 104 consiste en un polissage des faces du bloc comportant des rainures pour dé-courtcircuiter les connexions réalisées dans les rainures.

L'étape suivante 105 consiste à enrober l'ensemble dans un matériau électriquement isolant tel qu'une résine polymérisable. Enfin, l'étape 106 comporte la métallisation de l'ensemble enrobé pour réaliser un blindage.

La figure 6 représente partiellement le dispositif selon l'invention terminé. On y retrouve les conducteurs 21 et la face 302 du bloc 3' de la figure 5. Des rainures 40, 41 entaillent la face 302 jusqu'aux conducteurs 21. La métallisation des rainures 42 est celle qui subsiste après l'étape 104 de polissage de la face 302 qui enlève la métallisation sur cette face. La métallisation restante 42 assure la connexion entre les conducteurs correspondants des divers boîtiers. Le bloc 3' est enrobé par une résine 303 après l'étape 105, laquelle est recouverte d'une métallisation de blindage 304.

Les rainures peuvent être réalisées dans l'étape 102 par sciage, fraisage, par gravure laser ou tout autre technique connue.

Comme on peut le constater sur la figure 6, les capacités parasites sont maintenant pratiquement exclusivement celles existant entre les sections de métallisation 42 affleurant la face 302 et le blindage 304. Elles sont de la forme :

$$ C = 2\varepsilon_v \ \varepsilon_0 \ \frac{A'}{d} $$

L'aire A' est égale à e par millimètre de connexion.

Si on suppose une épaisseur e de 7 μm, on obtient alors une capacité de l'ordre de 0,005pF/mm, c'est-à-dire 0,05pF pour une longueur de connexion de 10 mm. On peut ainsi constater qu'on a divisé par 25 la capacité parasite.

Les figures 7A et 7B montrent d'autres formes de rainures obtenues selon la technique de découpe utilisée. Sur la figure 7A, la section des rainures 43 est trapézoïdale et, sur la figure 7B, la section des rainures 44 est partiellement circulaire.

Selon un autre aspect de l'invention, on peut penser à perfectionner ce procédé pour réaliser des barres omnibus d'alimentation avec condensateur réparti intégré ou reporté.

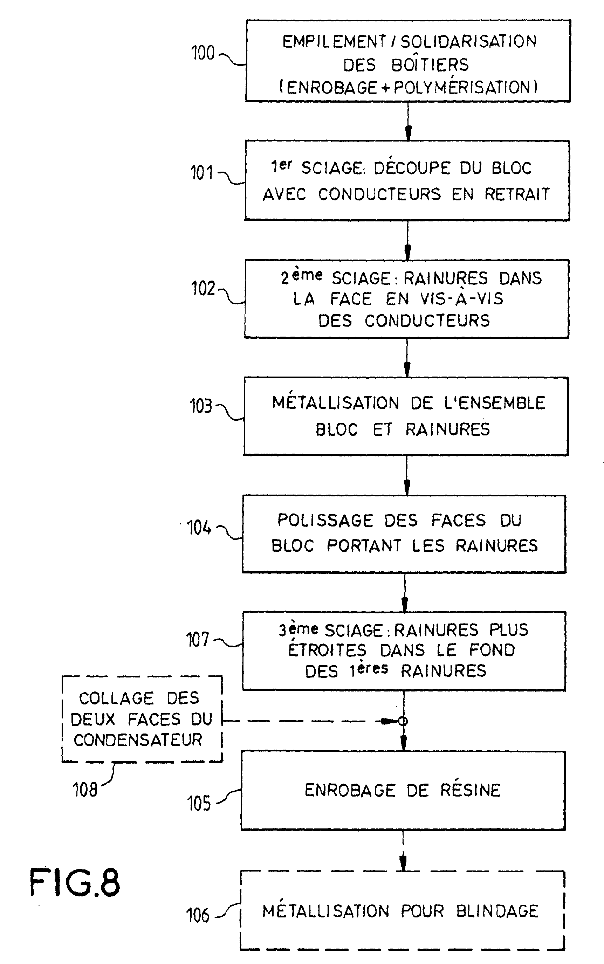

La figure 8 illustre cette variante de procédé selon l'invention. Par rapport au procédé de la figure 4, on a tout d'abord prévu que l'étape 102 de découpe de rainures devait, pour des rainures prédéterminées devant former lesdites barres, permettre d'entamer deux conducteurs adjacents d'alimentation desdits boîtiers. D'autre part, on a prévu d'insérer, entre l'étape 103 et l'étape 105, une étape 107 de découpe, dans le fond de ces rainures prédéterminées et sur toute leur longueur, de secondes rainures pour séparer ainsi deux électrodes Masse et Alimentation.

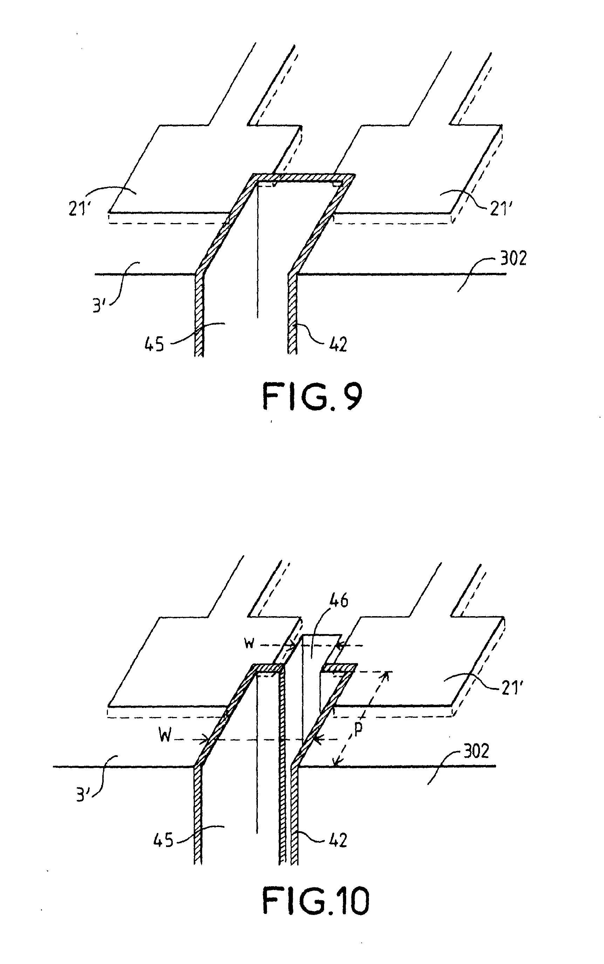

La figure 9 est une vue partielle du dispositif après l'étape 104. La rainure 45 entame deux conducteurs adjacents 21' du bloc 3' et ses faces ont une métallisation 42 affleurant la face polie 302.

La figure 10 montre une vue partielle après l'étape 107.

La seconde rainure 46 de largeur w inférieure à la largeur W de la rainure 45 a découpé la métallisation 42 pour former deux électrodes se faisant face.

L'étape 105 (figure 8) consiste ensuite à enrober l'ensemble bloc 3' - rainures 45,46 à l'aide d'un matériau électriquement isolant tel qu'une résine organique polymérisable. Ceci a pour but tout d'abord de refermer les rainures pour éviter que des poussières ou résidus de flux lors de brasage ne viennent polluer les conducteurs, connexions et électrodes. Cela permet ensuite de redéposer un dépôt métallique comme blindage de l'ensemble du module selon l'étape 106 facultative, si un blindage est nécessaire.

Enfin, cela permet d'obtenir une capacité répartie le long des deux électrodes. Habituellement, on utilise une résine époxy très chargée en particules minérales afin de réduire son coefficient de dilatation. On obtient une permittivité de l'ordre de 4. Dans ces conditions, avec une profondeur p de rainure de 1 mm et une largeur W de 200 μm, on a une capacité de l'ordre de 0,177 pF/mm. Avec une rainure de longueur 10 mm, on obtient une capacité de l'ordre de 1,77 pF.

Cependant, pour certaines applications, on peut utiliser une résine chargée en particules diélectriques, par exemple du titanate de baryum, pour atteindre des permittivités beaucoup plus élevées (typiquement quelques centaines). Ainsi avec une permittivité $\varepsilon_v$ = 400 , on obtiendrait une capacité de l'ordre de 177 pF.

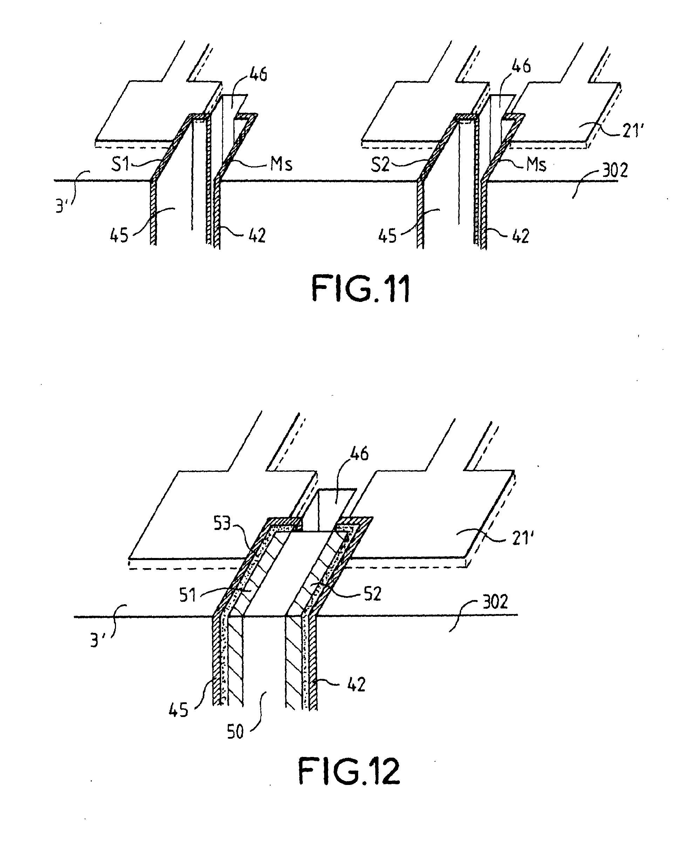

L'obtention dans une rainure 45 de deux électrodes se faisant face, comme représenté sur la figure 10, outre l'application indiquée ci-dessus pour réaliser des électrodes Masse et Alimentation, peut conduire à d'autres applications et, en particulier, celle illustrée sur la figure 11.

En effet, aux fréquences élevées, il peut exister entre deux connexions voisines de signal une diaphonie, c'est-à-dire l'induction d'un courant parasite d'une connexion sur la connexion adjacente. Avec des connexions réalisées sous forme coplanaire (sans rainures), on peut arriver à réduire la diaphonie en séparant les connexions par une connexion (également coplanaire) de masse. Mais ceci oblige à accroître notablement le pas des connexions de signal.

Le dispositif selon l'invention permet de remédier avantageusement à cet inconvénient, comme on le voit sur la figure 11. On y voit que, dans chaque rainure 45, une des électrodes, Ms, peut être reliée à la masse, de telle sorte que les électrodes de signal S1, S2 sont séparées l'une de l'autre par un blindage ou plan masse Ms. Les électrodes Ms peuvent être reliées à des conducteurs 21', comme à droite sur la figure 11, ou bien servir seulement de blindage en étant reliée à la masse sans être connectée à des conducteurs 21', comme à gauche sur la figure 11.

Une autre possibilité offerte par le dispositif de la figure 10 est la réalisation d'une barre omnibus d'alimentation avec condensateur reporté comme représenté sur la figure 12. Dans cette réalisation, on insère dans la rainure 45 un condensateur 50 comportant des métallisations formant électrodes 51, 52 sur deux faces opposées longitudinales. Ces faces sont disposées en regard des métallisations 42 formant les deux électrodes de la connexion et on relie entre elles les électrodes correspondantes, tout en fixant le condensateur, à l'aide d'un matériau électriquement conducteur, par exemple par collage avec une colle chargée en argent 53. Ceci permet de gagner en encombrement et d'avoir un dispositif protégé contre les courts-circuits et les pollutions grâce à l'enrobage de l'ensemble. En outre, cela permet de minimiser les self-inductances pour l'alimentation des différents étages empilés du bloc, car chaque étage est relié directement au condensateur 10, et d'équilibrer au mieux l'alimentation de tous les étages. L'insertion du condensateur est représentée par l'étape 108 sur la figure 8.

On peut remarquer que l'ordre des étapes 104 et 107 est interchangeable dans le schéma du procédé de la figure 8. Cependant, l'ordre indiqué sur cette figure est préférentiel car cela évite que des poussières conductrices résultant de l'opération 104 viennent se loger dans les secondes rainures 46.

Bien entendu, les exemples de réalisation décrits ne sont nullement limitatifs de l'invention ; notamment les connexions à réaliser sur les autres faces du bloc que celles où se trouvent les conducteurs de connexion 21, 21' peuvent aussi être réalisées sur le même principe de découpe de rainures pour limiter les capacités parasites.

## Revendications

1. Procédé d'interconnexion en trois dimensions de boîtiers ou circuits contenant au moins un composant électronique et munis de conducteurs de connexion, dans lequel lesdits boîtiers ou circuits sont empilés et solidarisés (100) par enrobage à l'aide d'un matériau électriquement isolant pour former un bloc (3, 3'), ledit procédé comportant les étapes suivantes :

   a) découpe du bloc;
   b) découpe dans les faces du bloc en vis-à-vis des extrémités des conducteurs et perpendiculairement à celles-ci de rainures venant au contact desdits conducteurs ;
   c) métallisation (103) du bloc et de ses rainures ;

   d) polissage (104) desdites faces du bloc pour éliminer la métallisation de ces faces ;
   e) enrobage (105) de l'ensemble du bloc par un matériau électriquement isolant ;
   ledit procédé étant **caractérisé en ce que** la découpe (101) de l'étape a) est effectuée en laissant les extrémités des conducteurs en retrait par rapport aux faces (302) correspondantes du bloc et **en ce que** la découpe (102) de rainures (40, 41 ; 43 ; 44) de l'étape b) est réalisée sur une profondeur suffisante pour entamer respectivement l'extrémité desdits conducteurs, et **en ce que** l'extrémité de ces conducteurs est plus large que les rainures au niveau de la jonction entre la rainure et le conducteur.

2. Procédé selon l'une des revendications 1 ou 2, **caractérisé en ce que** les rainures ont une section trapézoïdale ou partiellement circulaire.

3. Procédé selon l'une des revendications précédentes, **caractérisé en ce qu'**il comporte en outre une étape finale de :

   f) métallisation (106) du bloc pour assurer son blindage.

4. Procédé selon l'une des revendications précédentes, **caractérisé en ce que** les entames des rainures (40, 41 ; 43 ; 44 ; 45, 46) sont respectivement incluses selon leur largeur dans les extrémités des conducteurs (21).

5. Procédé selon l'une des revendications 1 à 3, incluant la réalisation, pour l'alimentation desdits boîtiers ou circuits, de barres omnibus d'alimentation, **caractérisé en ce que**, lors de l'étape b), au moins l'une prédéterminée desdites rainures (45) vient entamer l'extrémité de deux conducteurs adjacents d'alimentation desdits boîtiers ou circuits.

6. Procédé selon la revendication 5, **caractérisé en ce qu'**à la jonction entre les rainures prédéterminées et les secondes rainures, lesdites secondes rainures (46) ont une largeur inférieure à celle des rainures prédéterminées (45).

7. Procédé selon l'une quelconque des revendications précédentes, **caractérisé en ce que** lesdites découpes de rainures (40, 41 ; 43 ; 44 ; 45, 46) sont réalisées par sciage.

8. Procédé selon l'une quelconque des revendications 1 à 6, **caractérisé en ce que** lesdites découpes de rainures (40, 41 ; 43 ; 44 ; 45, 46) sont réalisées à l'aide d'un laser.

9. Procédé selon l'une des revendications 5 ou 6, **ca-**

**ractérisé en ce que**, juste avant l'étape e) d'enrobage, il est prévu une étape supplémentaire de :

> h) introduction, entre les faces latérales d'au moins une desdites rainures prédéterminées, d'un condensateur et collage sur chacune desdites faces latérales à l'aide d'une colle conductrice.

10. Dispositif électronique à interconnexion en trois dimensions comportant des boîtiers ou circuits contenant au moins un composant électronique et munis de conducteurs de connexion, dans lequel lesdits boîtiers ou circuits sont empilés et enrobés par un matériau électriquement isolant pour former un bloc (3, 3') dont les faces en vis-à-vis des extrémités desdits conducteurs comportent des rainures au contact de ceux-ci, **caractérisé en ce que** les extrémités desdits conducteurs (21 ; 21') sont en retrait par rapport auxdites faces en vis-à-vis du bloc, **en ce que** lesdites faces (302) comportent des rainures (40, 41 ; 43 ; 44 ; 45), qui ont une profondeur suffisante pour entamer les extrémités respectives desdits conducteurs (21 ; 21'), l'extrémité de ces conducteurs étant plus large que les rainures au niveau de la jonction entre la rainure et le conducteur, et dont les faces portent une métallisation (42), et **en ce que** ledit bloc comporte un matériau électriquement isolant (303) enrobant l'ensemble du bloc (3 ; 3') et des rainures.

11. Dispositif selon la revendication 10, **caractérisé en ce que** les rainures ont une section trapézoïdale ou partiellement circulaire.

12. Dispositif selon l'une des revendications 10 ou 11, **caractérisé en ce que** ledit bloc (3, 3') comporte en outre une couche métallique de blindage (304) recouvrant le matériau électriquement isolant (303) d'enrobage de l'ensemble.

13. Dispositif selon l'une des revendications 10 à 12, **caractérisé en ce que** des rainures prédéterminées (45) entament les extrémités de deux conducteurs adjacents (21') et **en ce que** la métallisation (42) du fond desdites rainures prédéterminées est interrompue sur toute la longueur desdites rainures.

14. Dispositif selon la revendication 13, **caractérisé en ce que**, entre les faces latérales d'au moins une desdites rainures prédéterminées (45), est disposé un condensateur fixé à ces faces latérales par un matériau conducteur électriquement.

FIG.1

DÉTAIL A

**FIG.2**

**FIG.3**

**FIG.5**

```
100 ⌐  ┌─────────────────────────────┐
        │  EMPILEMENT / SOLIDARISATION │
        │       DES  BOÎTIERS          │
        │  (ENROBAGE + POLYMÉRISATION) │
        └─────────────────────────────┘
                      │
                      ▼
101 ⌐  ┌─────────────────────────────┐
        │  1er SCIAGE: DÉCOUPE DU BLOC  │
        │  AVEC CONDUCTEURS EN RETRAIT │
        └─────────────────────────────┘
                      │
                      ▼
102 ⌐  ┌─────────────────────────────┐
        │  2ème SCIAGE: RAINURES DANS  │
        │   LA FACE EN VIS-À-VIS       │
        │      DES CONDUCTEURS         │
        └─────────────────────────────┘
                      │
                      ▼
103 ⌐  ┌─────────────────────────────┐
        │  MÉTALLISATION DE L'ENSEMBLE │
        │      BLOC  ET  RAINURES      │
        └─────────────────────────────┘
                      │
                      ▼
104 ⌐  ┌─────────────────────────────┐
        │  POLISSAGE DES FACES DU      │
        │  BLOC PORTANT LES RAINURES   │
        └─────────────────────────────┘
                      │
                      ▼
105 ⌐  ┌─────────────────────────────┐
        │     ENROBAGE DE RÉSINE       │
        └─────────────────────────────┘
                      │
                      ▼
106 ⌐  ┌─────────────────────────────┐
        │  MÉTALLISATION POUR BLINDAGE │
        └─────────────────────────────┘
```

# FIG.4

FIG.6

FIG.7A

FIG.7B

100 → EMPILEMENT / SOLIDARISATION DES BOÎTIERS (ENROBAGE + POLYMÉRISATION)

101 → 1er SCIAGE: DÉCOUPE DU BLOC AVEC CONDUCTEURS EN RETRAIT

102 → 2ème SCIAGE: RAINURES DANS LA FACE EN VIS-À-VIS DES CONDUCTEURS

103 → MÉTALLISATION DE L'ENSEMBLE BLOC ET RAINURES

104 → POLISSAGE DES FACES DU BLOC PORTANT LES RAINURES

107 → 3ème SCIAGE: RAINURES PLUS ÉTROITES DANS LE FOND DES 1ères RAINURES

COLLAGE DES DEUX FACES DU CONDENSATEUR

108

105 → ENROBAGE DE RÉSINE

FIG.8

106 → MÉTALLISATION POUR BLINDAGE

11

FIG. 9

FIG.10

**FIG.11**

**FIG.12**

Europäisches
Patentamt

European
Patent Office

Office européen
des brevets

## RAPPORT DE RECHERCHE EUROPEENNE

Numéro de la demande

EP 09 17 2209

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 0 490 739 A (THOMSON CSF) 17 juin 1992 (1992-06-17) * le document en entier * | 1-5,7-8, 10-12 | INV. H01L23/52 H01L21/50 H01L25/00 |
| Y | WO 95/25341 A (IRVINE SENSORS) 21 septembre 1995 (1995-09-21) * page 12, ligne 14 - page 14, ligne 5 * * page 15, ligne 2 - page 16, ligne 25 * * figures 9-12,14-16 * | 1-5,7-8, 10-12 | H01L25/065 H01L23/522 H01L21/98 |
| Y | EP 0 593 330 A (THOMSON CSF) 20 avril 1994 (1994-04-20) * colonne 5, ligne 45 - ligne 58 * * colonne 4, ligne 44-56; figure 8 * | 1-5,7-8, 10-12 | |
| A | P SINGER: "Making the Move to Dual Damascene Processing" SEMICONDUCTOR INTERNATIONAL,US,NEWTON, MAS, IL, vol. 20, no. 9, août 1997 (1997-08), pages 79-80,82, XP002114089 ISSN: 0163-3767 * le document en entier * | 6,13 | |
| A | FR 2 529 386 A (INF MILIT SPATIALE AERONAUT) 30 décembre 1983 (1983-12-30) * page 7, ligne 15 - ligne 28; figure 5 * | 3,12 | |
| A | FR 2 726 941 A (CIMSA CINTRA) 15 mai 1996 (1996-05-15) * page 1, ligne 13 - ligne 26 * | 3,12 | |
| A | EP 0 638 933 A (THOMSON CSF) 15 février 1995 (1995-02-15) * colonne 7, ligne 9 - ligne 23; figure 1 * | 1,10 | |

DOMAINES TECHNIQUES
RECHERCHES (IPC)

H01L

-/--

Le présent rapport a été établi pour toutes les revendications

| Lieu de la recherche | Date d'achèvement de la recherche | Examinateur |
|---|---|---|
| Munich | 16 novembre 2009 | Le Gallo, Thomas |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

..........................................................................

& : membre de la même famille, document correspondant

EPO FORM 1503 03.82 (P04C02)

**EP 2 136 401 A1**

Europäisches
Patentamt

European
Patent Office

Office européen
des brevets

# RAPPORT DE RECHERCHE EUROPEENNE

Numéro de la demande

EP 09 17 2209

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | FR 2 645 681 A (THOMSON CSF) 12 octobre 1990 (1990-10-12) * revendications 1-11; figures 2,6 * ----- | 1-14 | |
| A | S.F. AL-SARAWI ET AL: "a review of 3-d packaging technology" IEEE TRANSACTIONS ON COMPONENTS, PACKAGING AND MANUFACTURING TECHNOLOGY. PART B: ADVANCED PACKAGING., vol. 21, no. 1, février 1998 (1998-02), pages 2-14, XP002162813 IEEE SERVICE CENTER, PISCATAWAY, NJ., US ISSN: 1070-9894 * page 5, colonne de droite; figures 8,9 * ----- | 1-14 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| Munich | 16 novembre 2009 | Le Gallo, Thomas |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

    .............................................................................................
& : membre de la même famille, document correspondant

EPO FORM 1503 03.82 (P04C02)

**EP 2 136 401 A1**

**ANNEXE AU RAPPORT DE RECHERCHE EUROPEENNE
RELATIF A LA DEMANDE DE BREVET EUROPEEN NO.**
EP 09 17 2209

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-11-2009

| Document brevet cité au rapport de recherche | | Date de publication | Membre(s) de la famille de brevet(s) | | Date de publication |
|---|---|---|---|---|---|
| EP 0490739 | A | 17-06-1992 | DE | 69126599 D1 | 24-07-1997 |
| | | | DE | 69126599 T2 | 02-10-1997 |
| | | | ES | 2104681 T3 | 16-10-1997 |
| | | | FR | 2670323 A1 | 12-06-1992 |
| | | | WO | 9210853 A1 | 25-06-1992 |
| | | | JP | 3415621 B2 | 09-06-2003 |
| | | | JP | 5505067 T | 29-07-1993 |
| WO 9525341 | A | 21-09-1995 | US | 5688721 A | 18-11-1997 |
| EP 0593330 | A | 20-04-1994 | DE | 69322477 D1 | 21-01-1999 |
| | | | DE | 69322477 T2 | 29-04-1999 |
| | | | FR | 2696871 A1 | 15-04-1994 |
| | | | JP | 3483280 B2 | 06-01-2004 |
| | | | JP | 7007130 A | 10-01-1995 |
| | | | US | 5526230 A | 11-06-1996 |
| FR 2529386 | A | 30-12-1983 | AUCUN | | |
| FR 2726941 | A | 15-05-1996 | DE | 3702780 A1 | 04-07-1996 |
| | | | GB | 2300514 A | 06-11-1996 |
| EP 0638933 | A | 15-02-1995 | CA | 2146868 A1 | 23-02-1995 |
| | | | DE | 69420917 D1 | 04-11-1999 |
| | | | DE | 69420917 T2 | 17-02-2000 |
| | | | FR | 2709020 A1 | 17-02-1995 |
| | | | WO | 9505677 A1 | 23-02-1995 |
| | | | JP | 8502631 T | 19-03-1996 |
| | | | US | 5637536 A | 10-06-1997 |
| FR 2645681 | A | 12-10-1990 | AUCUN | | |

EPO FORM P0460

## RÉFÉRENCES CITÉES DANS LA DESCRIPTION

**Documents brevets cités dans la description**

- FR 2670323

- FR 2688630